# EUROPEAN PATENT APPLICATION

(11) **EP 1 524 298 A1**
(43) Date of publication of application: **20.04.2005**
(21) Application number: 04106878.4
(22) Date of filing: 22.12.2004
(51) Int. Cl.: C08L 81/06

(54) **Sulfone polymer composition**

(71) Applicant: Solvay Advanced Polymers, L.L.C., Alpharetta, GA 30005-3914 (US)
(72) Inventor: El-Hibri, Mohammad Jamal, GA 30328, Atlanta (US)
(74) Representative: Jacques, Philippe

(57) **Abstract**

The invention relates to a sulfone polymer composition comprising :
- at least one high glass transition temperature sulfone polymer (A)
- at least one highly tough sulfone polymer (B)
with the exception of a sulfone polymer composition composed of 50 % wt of polyphenylsulfone and 50 % wt of polybiphenyldisulfone.

The sulfone polymer composition of the invention possesses advantageously thermal performances and toughness advantages in addition to minor cost with respect to high glass transition sulfone polymers.

## Description

Numerous blends of various poly(aryl ether sulfone) have been described in US 4,804,723 (to Amoco Corporation), to the specific purpose of providing miscible compositions. Thus, example 2 of said patent discloses a miscible blend composed of 50 parts by weight of polyphenylsulfone and 50 parts by weight of polybiphenyldisulfone. The problem of providing a sulfone polymer composition having a good balance between high temperature performances and resilience, especially impact resistance, is not addressed.

In contrast, the invention concerns a sulfone polymer composition having a good balance between high temperature performances and resilience, and an article comprising said composition.

High glass transition temperature sulfone polymers are appreciated because of their outstanding heat resistance, dimensional stability, good chemical resistance and mechanical integrity up to operating temperature of about 250°C.

Nevertheless, these high glass transition temperature sulfone polymers present several drawbacks, in particular a poor toughness, which make them unsuitable for application where impact resistance is required. Moreover, they are highly costly, due to the expensive monomers required for their synthesis.

The above-mentioned drawbacks and others are remarkably overcome by a sulfone polymer composition comprising :
- at least one high glass transition temperature sulfone polymer [polymer (A)]
- at least one highly tough sulfone polymer [polymer (B)]
with the exception of a sulfone polymer composition composed of 50 % wt of polyphenylsulfone and 50 % wt of polybiphenyldisulfone.

The composition of the invention possesses advantageously thermal performances and toughness advantages in addition to minor cost with respect to high glass transition sulfone polymers.

For the purpose of the invention, the term "polymer" is intended to denote any material consisting essentially of recurring units, and having a molecular weight above 2000.

For the purpose of the invention, the term "high glass transition temperature sulfone polymer" is intended to denote any polymer, at least 50 % wt of recurring units thereof being recurring units (R1):

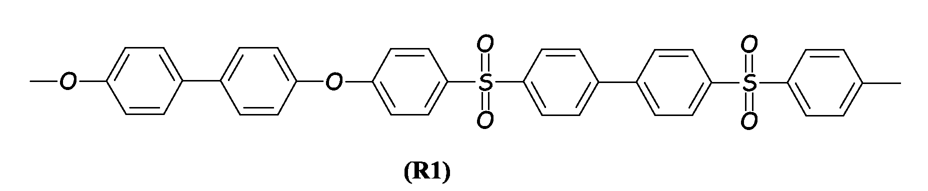

Optionally, polymer (A) further comprises recurring units (R2) : 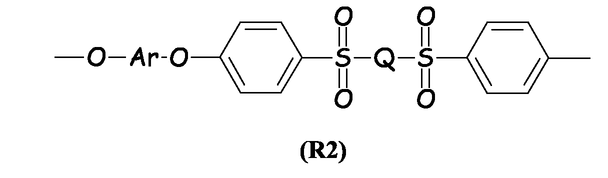 wherein :
- Q is a group chosen among the following structures : 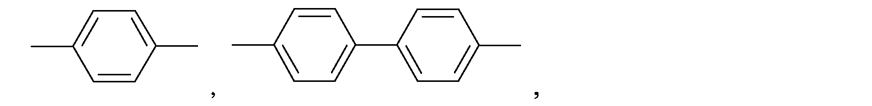 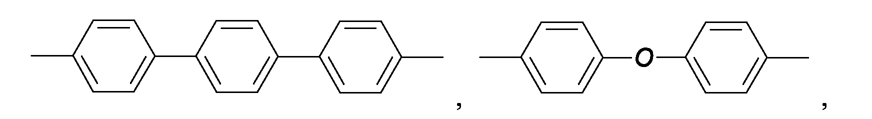 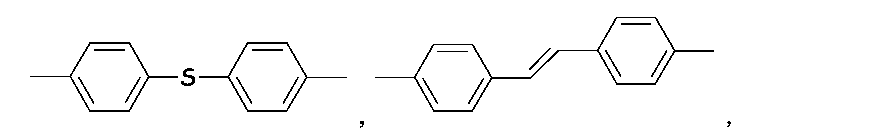 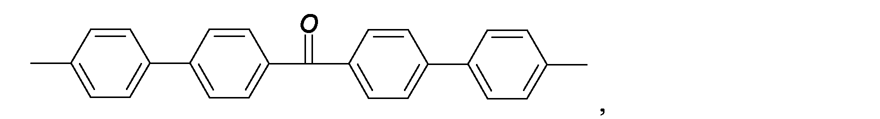 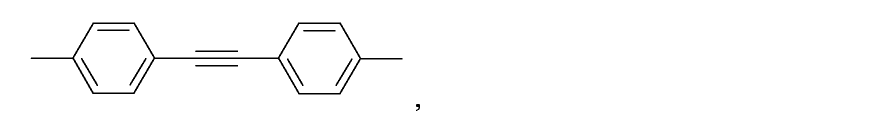 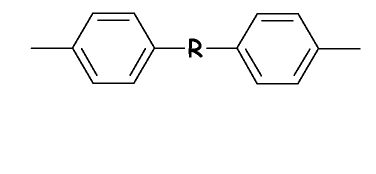 with **R** being : 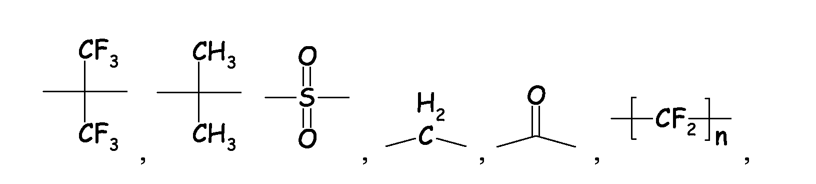 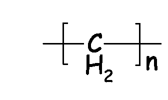 with n = integer from 1 to 6, or an aliphatic divalent group, linear or branched, of up to 6 carbon atoms;
   and mixtures thereof; and
- Ar is a group chosen among the following structures : 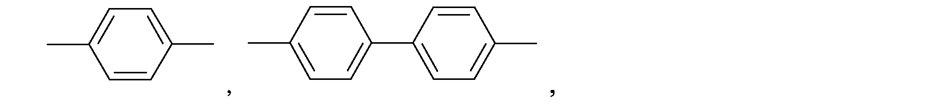 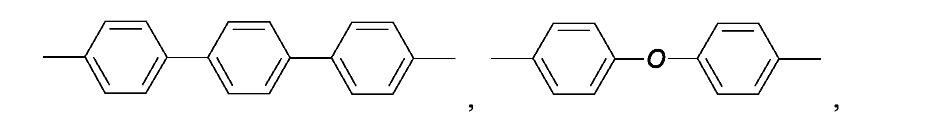 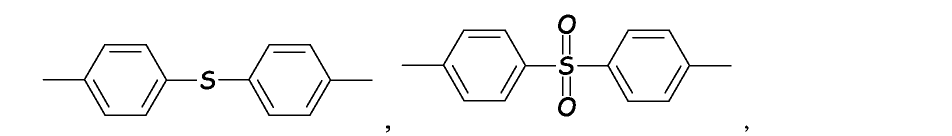 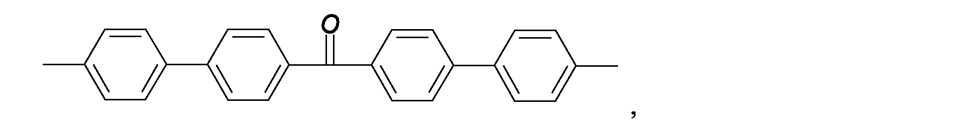 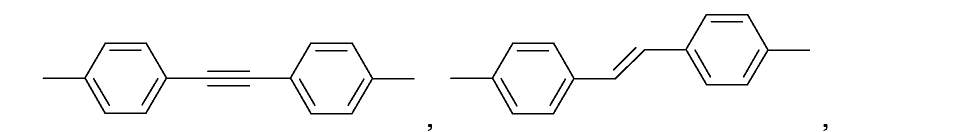 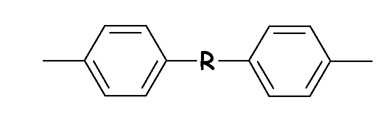 with **R** being : 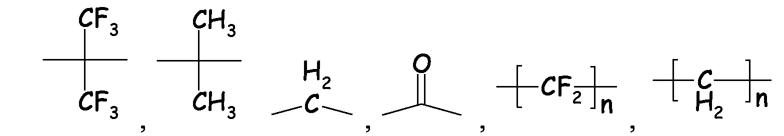 with n = integer from 1 to 6, or an aliphatic divalent group, linear or branched, of up to 6 carbon atoms;
   and mixtures thereof.

Recurring units (R2) are preferably chosen from : 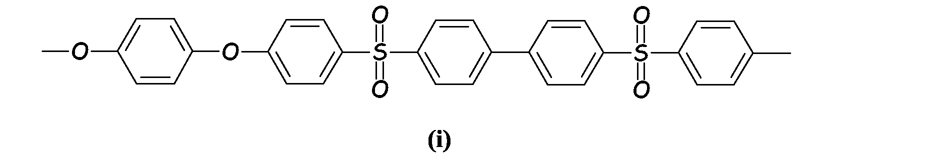 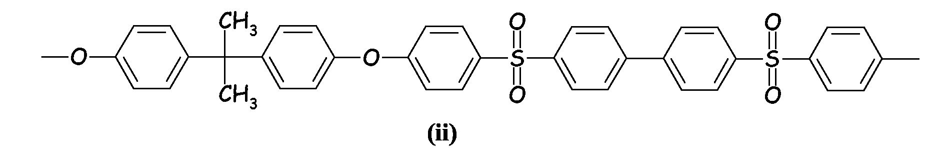 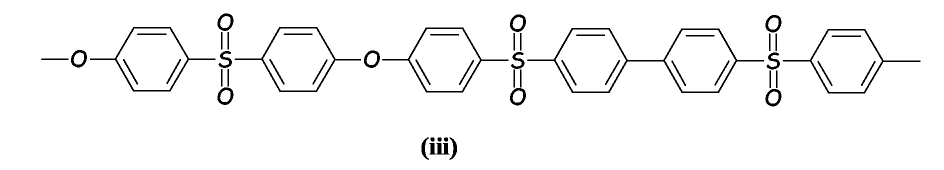 and mixtures therefrom.

Polymer (A) can be either a homopolymer or a random, alternating or block copolymer.

Preferably 70 % wt, more preferably 75 % wt of the recurring units of polymer (A) are recurring units (R1). Still more preferably, polymer (A) is a homopolymer of recurring units (R1).

Polymer (A) obtained from the polycondensation of 4,4'-bis-(4-chlorophenyl sulfonyl)biphenyl and 4,4'-dihydroxydiphenyl (polybiphenyldisulfone, hereinafter) is an example of homopolymer.

Polymer (A) has a glass transition temperature of advantageously at least 230°C, preferably at least 240°C, more preferably at least 250°C.

In a first preferred embodiment of the invention, the sulfone polymer composition comprises less than 50 % wt, preferably less than or equal to 49 % wt, more preferably less than or equal to 48 % wt, still more preferably less than or equal to 47 % wt of polymer (A), with respect to the total weight of (A) and (B).

In this embodiment, excellent results were obtained with sulfone polymer compositions comprising less than or equal to 45 % wt of polymer (A), with respect to the total weight of (A) and (B).

In this embodiment, the sulfone polymer composition advantageously comprises at least 10 % wt, preferably at least 15 % wt, more preferably at least 20 % wt, still more preferably at least 30 % wt, most preferably at least 40 % wt of polymer (A), with respect to the total weight of (A) and (B).

In a second preferred embodiment of the invention, the sulfone polymer composition comprises more than 50 % wt of polymer (A), preferably more that or equal to 51 % wt, more preferably more that or equal to 52 % wt, still more preferably more that or equal to 53 % wt with respect to the total weight of (A) and (B).

In this embodiment, excellent results were obtained with sulfone polymer compositions comprising more than or equal to 55 % wt of polymer (A), with respect to the total weight of (A) and (B).

In this embodiment, the sulfone polymer composition comprises at most 90 % wt, preferably at most 85 % wt, more preferably at most 80 % wt, still more preferably at most 70 % wt, most preferably at most 60 % wt of polymer (A), with respect to the total weight of (A) and (B).

For the purpose of the invention, the term "highly tough sulfone polymer" (B) is intended to denote any polymer, at least 50 % wt of recurring units thereof being recurring units (R3):

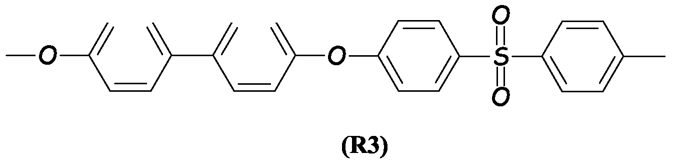

Optionally, polymer (B) further comprises recurring units (R4) : 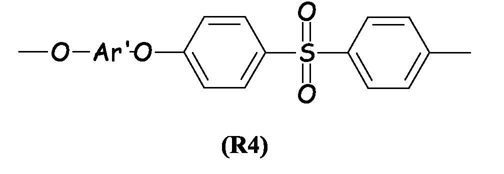 wherein Ar' is a group chosen among the following structures : 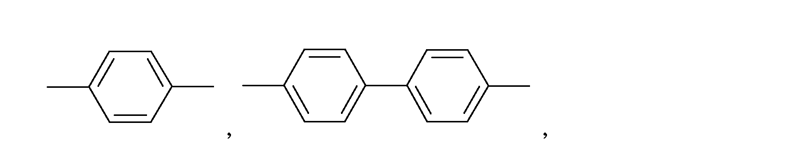 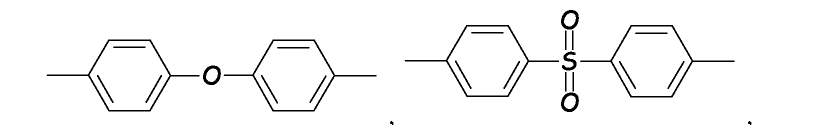 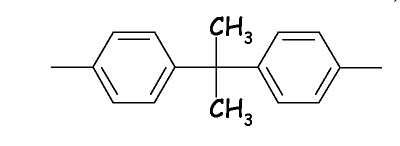 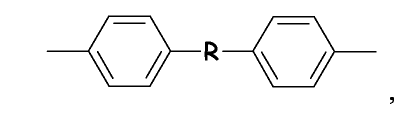 , with R being an aliphatic divalent group of up to 6 carbon atoms, such as methylene, ethylene, isopropylene and the like.

Recurring units (R4) are preferably chosen from : 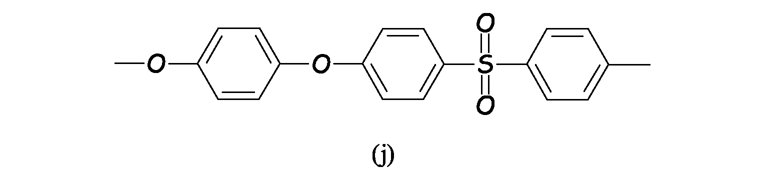 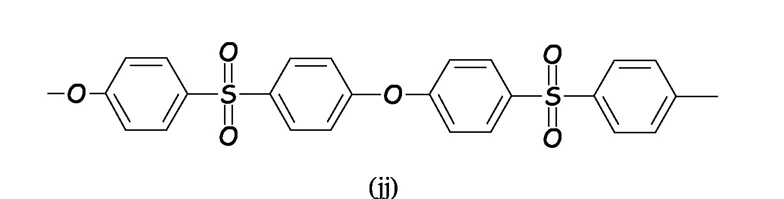 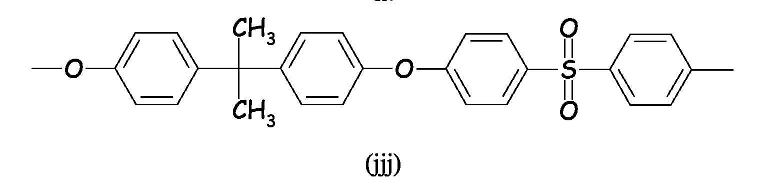 and mixtures therefrom.

Polymer (B) may notably be a homopolymer, a random, alternating or block copolymer.

Preferably at least 70 % wt, more preferably at least 75 % wt of the recurring units of polymer (B) are recurring units (R3). Still more preferably, polymer (B) is a homopolymer of recurring units (R3).

RADEL® R PPSF polyphenylsulfone from Solvay Advanced Polymers, L.L.C. is an example of homopolymer.

Polymer (B) has an impact resistance of advantageously at least 8 ft-lb/in, preferably of at least 9 ft-lb/in, more preferably of at least 10.0 ft-lb/in when measured by Notched Izod according to ASTM D256 (Test method A) at 25°C.

The polymer composition of the invention exhibits a glass transition temperature of advantageously at least 220°C, preferably at least 225°C, more preferably at least 230°C.

The polymer composition of the invention exhibits an impact resistance of advantageously at least 7 ft-lb/in, preferably of at least 8 ft-lb/in, more preferably of at least 9.0 ft-lb/in, still more preferably of at least 10.0 ft-lb/in when measured by Notched Izod according to ASTM D256 (Test method A) at 25°C.

The polymer composition of the invention may notably further comprises at least one filler. The filler is preferably chosen from glass fiber, carbon or graphite fibers, fibers formed of silicon carbide, alumina, titania, boron, flake, spherical and fibrous particulate filler reinforcements and nucleating agents such as talc, mica, titanium dioxide, potassium titanate, silica, kaolin, chalk, alumina, mineral fillers, and the like.

The polymer composition of the invention may also further comprise notably pigments, stabilizers, i.e., metal oxides such as zinc oxide, antioxidants and/or flame retardants.

Another object of the invention is an article comprising the polymer composition as above described.

Advantageously the article is an injection molded article, an extrusion molded article, a shaped article, a coated article or a casted article.

The articles according to the invention can be fabricated by processing the polymer composition as above described following standard methods.

Non limitative examples of articles are shaped articles, electronic components (such as printed circuit boards, electrical plug-in connectors, bobbins for relays and solenoids), pipes, fittings, housings, films, membranes, coatings.

Another aspect of the present invention concerns a process for manufacturing the polymer composition as above described, which comprises mixing the polymer (A) and the polymer (B).

Advantageously, the process comprises mixing by dry blending and/or melt compounding the polymer (A) and the polymer (B).

Preferably, the polymer (A) and the polymer (B) are mixed by melt compounding.

Advantageously, the polymer (A) and the polymer (B) are melt compounded in continuous or batch devices. Such devices are well-known to those skilled in the art.

Examples of suitable continuous devices to melt compound the polymer composition of the invention are notably screw extruders. Thus, the polymer (A), the polymer (B), and optionally other ingredients, are advantageously fed in powder or granular form in an extruder and the polymer composition, as above described is advantageously extruded into strands and the strands are advantageously chopped into pellets.

Optionally, fillers, lubricating agents, heat stabilizer, anti-static agents, extenders, reinforcing agents, organic and/or inorganic pigments like TiO₂, carbon black, acid scavengers, such as MgO, flame-retardants, smoke-suppressing agents may be added to the composition during the compounding step.

Preferably, the polymer (A) and the polymer (B) are melt compounded in a twin-screw extruder.

The polymer composition of the invention can be processed following standard methods for injection molding, extrusion, thermoforming, machining, and blow molding. Solution-based processing for coatings and membranes is also possible. Finished articles comprising the polymer composition as above described can undergo standard post-fabrication operations such as ultrasonic welding, adhesive bonding, and laser marking as well as heat staking, threading, and machining.

The present invention is described in greater detail below by referring to the Examples; however, the present invention is not limited to these examples.

### Raw materials :

Polybiphenyldisulfone obtained from the polycondensation of 4,4'-bis-(4-chlorophenyl sulfonyl)biphenyl and 4,4'-dihydroxydiphenyl was used. The table 1 here below summarizes main properties of the material used in preparing the composition:

**Table 1 -**

| **Properties of the polybiphenyldisulfone** | | |
|---|---|---|
| | | Polybiphenyldisulfone |
| GPC measurements | Mₙ (Dalton) | 17670 |
| | M_{w} (Dalton) | 47200 |
| | M_{w}/Mₙ | 2.67 |
| DSC measurements | T_{g} (°C) | 264.7 |
| Melt flow index^{(†)} | MFI [400°C/5 kg] (g/10 min) | 28.5 |
| Mechanical Properties | Tensile Modulus^{(◊)} (Kpsi) | 312 |
| | Elongation at yield^{(◊)} (%) | 8.5 |
| | Elongation at break^{(◊)} (%) | 18.0 |
| | Notched Izod ^{(‡)} (ft-lb/in) | 3.1 ^{(*)} |
| | HDT [annealed] ^{(§)}(°C) | n.d. |

| | | |
|---|---|---|
| (†) Melt flow index measured according to ASTM D 1238, at a temperature of 400°C, under a load of 5 kg. | | |
| (◊) Tensile properties measured according to ASTM D 638. | | |
| (‡) Notched Izod has been measured at 25°C according to ASTM D256 (Test method A). | | |
| (§) Test parts were annealed at 250°C for 1 hour prior to HDT testing. Heat Deflection Temperature (HDT) has been measured according to ASTM D648. | | |
| (*) Izod break type : Complete. | | |

RADEL® R-5800 NT polyphenylsulfone commercially available from Solvay Advanced Polymers, a sulfone polymer obtained from the polycondensation of a 4,4'-dihalodiphenylsulfone and 4,4'-dihydroxydiphenyl, has been used. Table 2 here below summarizes main properties of the material used in preparing the compositions :

**Table 2 -**

| **Properties of the polyphenylsulfone** | | |
|---|---|---|
| | | RADEL® R-5800 NT polyphenylsulfone |
| DSC measurements | T_{g} (°C) | 219.4 |
| Melt flow index^{(†)} | MFI [400°C/5 kg] (g/10 min) | 46.4 |
| Mechanical Properties | Tensile Modulus^{(◊)} (Kpsi) | 414 |
| | Elongation at yield^{(◊)} (%) | 7.3 |
| | Elongation at break^{(◊)} (%) | 110 |
| | Notched Izod ^{(‡)} (ft-lb/in) | 12.8^{(†)} |
| | HDT [annealed] ^{(§)}(°C) | 210 |

| | | |
|---|---|---|
| (†) Melt flow index measured according to ASTM D 1238, at a temperature of 400°C, under a load of 5 kg. | | |
| (◊) Tensile properties measured according to ASTM D 638. | | |
| (‡) Notched Izod has been measured at 25°C according to ASTM D256 (Test method A). | | |
| (§) Test parts were annealed at 200°C for 1 hour prior to HDT testing. Heat Deflection Temperature (HDT) has been measured according to ASTM D648. (†) Izod break type : Partial | | |

### Compounding procedure :

The compositions were melt compounded using a 25 mm diameter twin screw double vented Berstorff extruder having an L/D ratio of 33/1 according to the temperature profile shown in Table 1. The first vent port was open to the atmosphere; the second was connected to a vacuum pump. The extruder was fitted with a double strand die. The polymer extrudate was pelletized after passing through a water trough for cooling. The blend was extruded and pelletized without incident at the throughput rates indicated in Table 3.

**Table 3 -**

| **Compounding conditions** | |
|---|---|
| Barrel temperature (°C) | |
| Throat | No heat |
| Zone 1 | 315 |
| Zone 2 | 335 |
| Zone 3 | 335 |
| Zone 4 | 340 |
| Zone 5 | 335 |
| Zone 6 | 340 |
| Zone 7 | 330 |
| Die | 345 |
| | |
| Melt temperature | 390-410 °C |
| Screw Speed | 200 rpm |
| Throughput rate | 14 lb/hr |
| Vent 1 (at zone 1) | Open to atmosphere |
| Vent 2 (at zone 6) | 30 in Hg Vacuum |

### Injection molding procedure

Following compounding, the resin pellets from the various resins and composition were dried for about 16 hrs in a 149°C (300 F) desiccated hot air oven with a due point of -37.2°C (-35 F). Parts were then injection molded into 1/8" thick ASTM tensile and flexural test specimens using a Wasp Mini-Jector benchtop injection molding machine equipped with a 3/4" general purpose screw and a 20 L/D. Injection molding machine temperature settings were 395°C, 400°C and 405°C for the rear, front and nozzle sections respectively. An injection pressure of 1100 psi was used along with a mold temperature of 85°C (185 F) and a screw speed of 60 RPM.

### Mechanical Properties Determinations

A standard flexural bar 5" × ½" × ⅛" was used for ASTM D648 HDT determinations and for ASTM D256 Notched Izod measurements (Test method A). A type I ASTM tensile bar, 4.5" in gage length x ½" wide × ⅛ " thick was used for ASTM D638 Tensile properties determinations.

### Example 1

A blend of the polybiphenyldisulfone and of RADEL® R-5800 NT polyphenylsulfone was prepared by melt compounding as specified here above. Details of composition and characterization of the blend are summarized in Table 4 here below.

**Table 4 -**

| **Composition and characterization of the blend** | | |
|---|---|---|
| | | **Example 1** |
| Composition | Polybiphenyldisulfone (% wt) | 55 |
| | RADEL® R-5800 NT polyphenylsulfone (% wt) | 45 |
| DSC measurements | T_{g} (°C) | 244.3 |
| Melt flow index^{(†)} | MFI [400°C/5 kg] (g/10 min) | 42.3 |
| Mechanical Properties | Tensile Modulus^{(◊)} (Kpsi) | 320 |
| | Elongation at yield^{(◊)} (%) | 7.9 |
| | Elongation at break^{(◊)} (%) | 67 |
| | Notched Izod^{(‡)} (ft-lb/in) | 10.0 |
| | HDT [annealed] ^{(§)} (°C) | 233.7 |
| Transparency | (comments) | Transparent |

| | | |
|---|---|---|
| (†) Melt flow index measured according to ASTM D 1238, at a temperature of 400°C, under a load of 5 kg. | | |
| (‡) Notched Izod has been measured at 25°C according to ASTM D256 (Test method A). | | |
| (§) Test parts were annealed at 230°C for 1 hour prior to HDT testing. Heat Deflection Temperature (HDT) has been measured according to ASTM D648. | | |
| (◊) Tensile properties measured according to ASTM D 638. | | |

## Claims

1. Sulfone polymer composition comprising :
― at least one high glass transition temperature sulfone polymer [polymer (A)], at least 50 % wt of the recurring units thereof are recurring units (R1) : 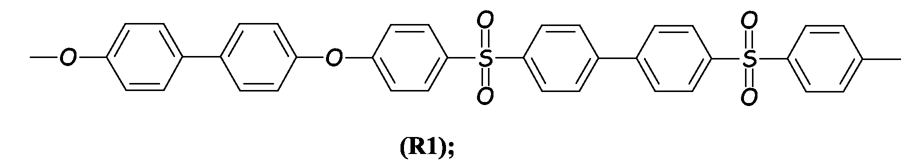
― at least one highly tough sulfone polymer [polymer (B)], at least 50 % wt of the recurring units thereof are recurring units (R3) : 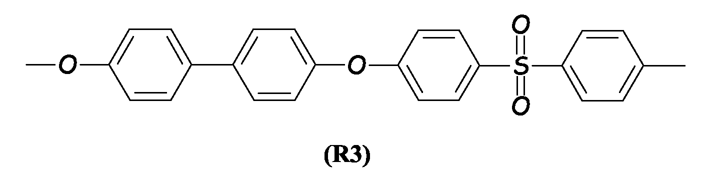 with the exception of a sulfone polymer composition composed of 50 % wt of polyphenylsulfone and 50 % wt of polybiphenyldisulfone.

2. Composition according to Claim 1, **characterized in that** polymer (A) comprises recurring units (R2) : 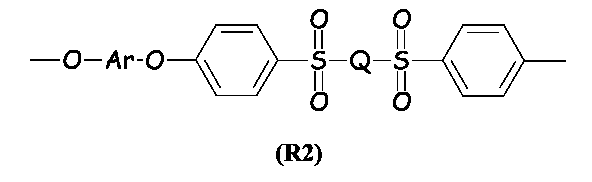 wherein :
- Q is a group chosen among the following structures : 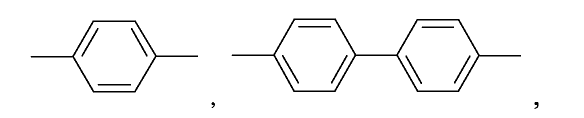 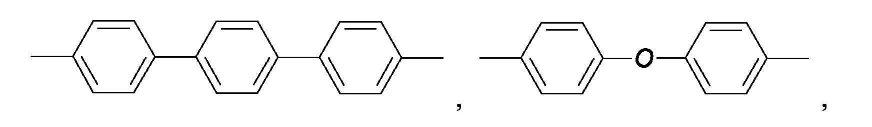 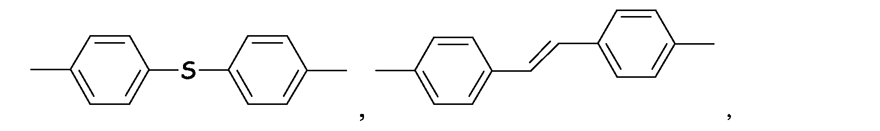 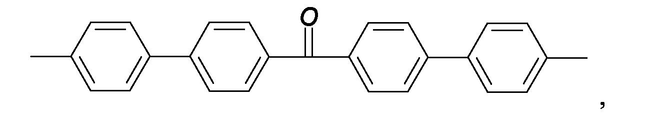 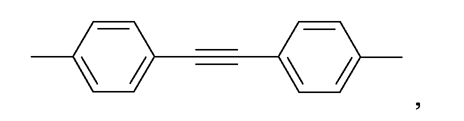 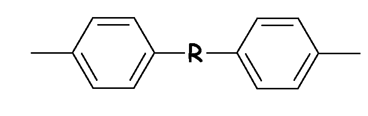 with **R** being : 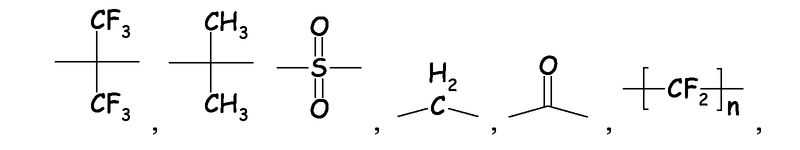 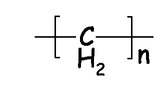 with n = integer from 1 to 6, or an aliphatic divalent group, linear or branched, of up to 6 carbon atoms;
and mixtures thereof; and
- Ar is a group chosen among the following structures : 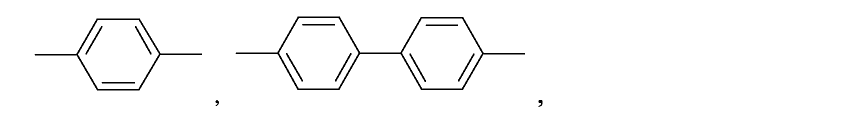 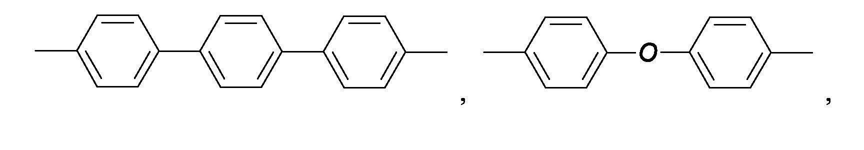 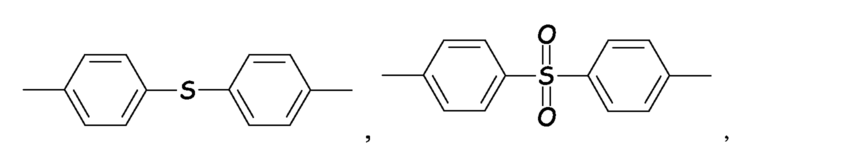 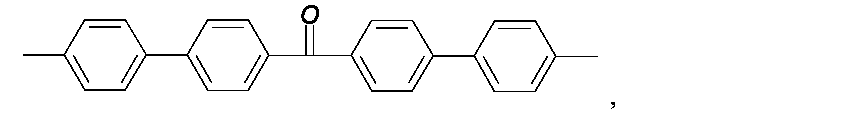 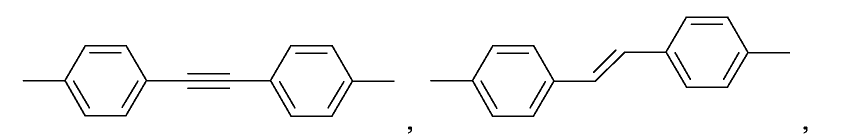 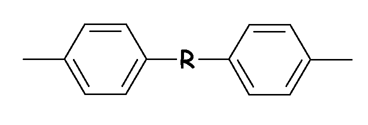 with R being : 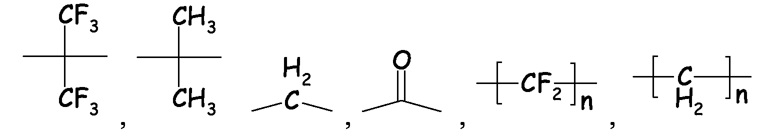 with n = integer from 1 to 6, or an aliphatic divalent group, linear or branched, of up to 6 carbon atoms;
and mixtures therof.

3. Composition according to Claim 2, **characterized in that** recurring units (R2) are chosen from :

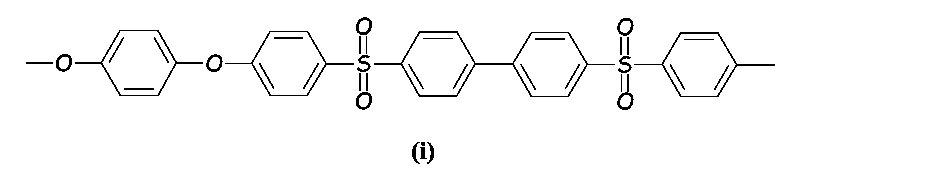

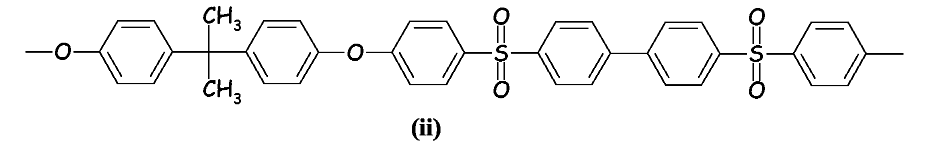

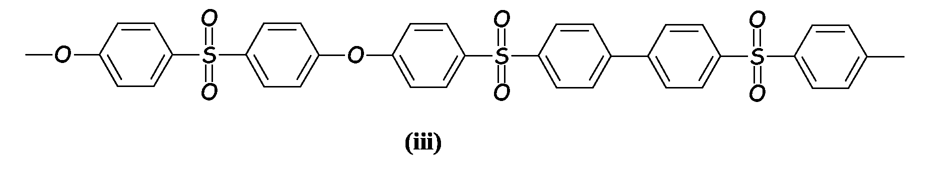

4. Composition according to Claim 1, **characterized in that** polymer (A) is a homopolymer of recurring units (R1).

5. Composition according to anyone of Claims 1 to 4 **characterized in that** polymer (B) is a homopolymer of recurring units (R3) :

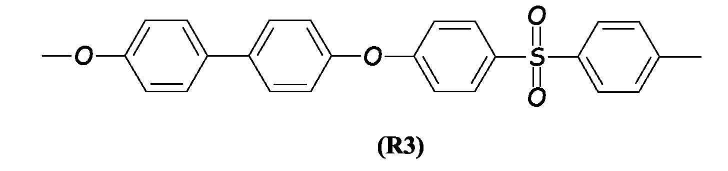

6. Composition according to anyone of the preceding Claims, comprising less than 50 % wt of polymer (A), with respect to the total weight of (A) and (B).

7. Composition according to anyone of Claims 1 to 5, comprising more than 50 % wt of polymer (A), with respect to the total weight of (A) and (B).

8. Composition according to anyone of the preceding Claims, **characterized in that** it comprises at least one filler.

9. Article comprising the composition according to anyone of the preceding Claims.

10. Process for manufacturing the composition according to anyone of Claims 1 to 8, which comprises mixing the polymer (A) and the polymer (B).
